# EUROPEAN PATENT APPLICATION

(11) **EP 1 722 483 A2**
(43) Date of publication of application: **15.11.2006**
(21) Application number: 06111599.4
(22) Date of filing: 23.03.2006
(51) Int. Cl.: H04B 1/18

(54) **Switch circuit**

(30) Priority: 10.05.2005 JP 2005137478
(71) Applicant: ALPS ELECTRIC CO., LTD., Ota-ku Tokyo 145 (JP)
(72) Inventor: Sato, Keiichiro, 1-7 Yukigaya Otsuka-cho Ota-ku Tokyo (JP)
(74) Representative: Kensett, John Hinton

(57) **Abstract**

A switch circuit includes a first input terminal, a second input terminal, an output terminal which is selectively connected to the first input terminal or the second input terminal, terminators for terminating the first input terminal or the second input terminal. When the first input terminal is connected to the output terminal, the second input terminal is terminated by the terminator. When the second input terminal is connected to the output terminal, the first input terminal is terminated by the terminator.

## Description

### BACKGROUND OF THE INVENTION

### 1. Field of the Invention

The present invention relates to a single pole double throw (SPDT) type switch circuit suitable for use in an outdoor converter (BS converter) to receive satellite broadcast signal.

### 2. Description of the Related Art

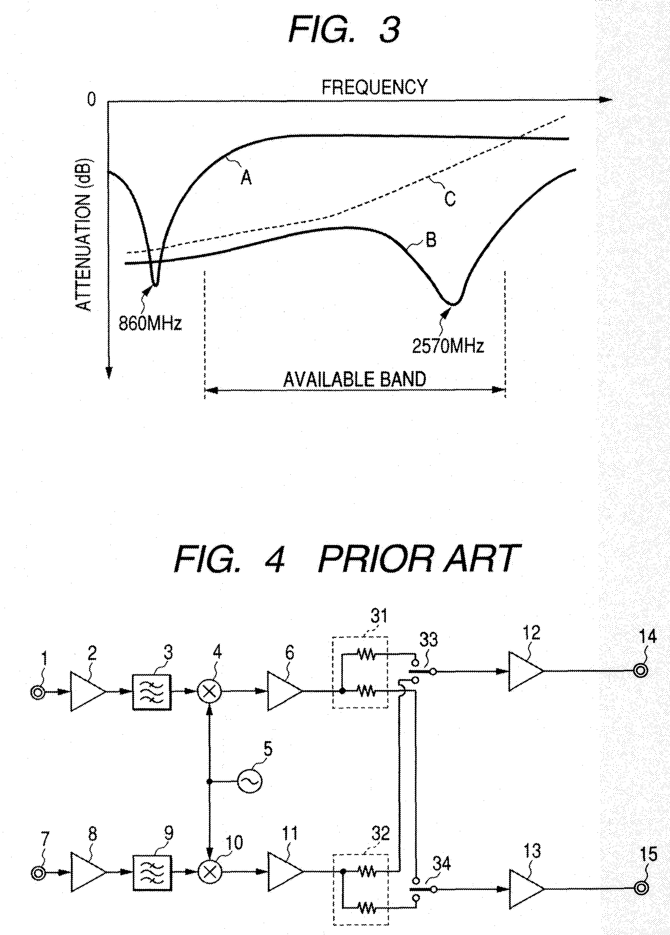

A conventional BS converter using a single pole double throw type switch circuit will be described with reference to Fig. 4. Left turning satellite broadcasting signals of a 12 GHz band input to a first input terminal 1 are input to a first mixer 4 through a first low-noise amplifier 2 and a first band pass filter 3. Local oscillation signals are transmitted to the first mixer 4 from a local oscillator 5. A first intermediate frequency signal of about 1 GHz output from the first mixer 4 is input to a first resistance divider 31 through a first intermediate frequency head amplifier 6.

In the meantime, right turning broadcasting signals of a 12 GHz band input to a second input terminal 7 are input to a second mixer 10 through a second low-noise amplifier 8 and a second band pass filter 9. Local oscillation signals are transmitted to the second mixer 10 as well. A second intermediate frequency signal of about 1 GHz output from the second mixer 10 is input to a second resistance divider 32 through a second intermediate frequency head amplifier 11.

One of one side of the first intermediate frequency signal divided by the first resistance divider 31 and one side of the second intermediate frequency signal divided by the second resistance divider 32 is selected by a first converting switch 33, and is then output to a first output terminal 14 through a first intermediate frequency output amplifier 12.

Similarly, One of the other side of the first intermediate frequency signal divided by the first resistance divider 31 and the other side of the second intermediate frequency signal divided by the second resistance divider 32 is selected by a second converting switch 34, and is then output to a second output terminal 15 through a second intermediate frequency output amplifier 13 (For example, see JP-A-2004-235801 (Fig. 1)).

Each of the first converting switch 33 and the second converting switch 34 includes two pin diodes. When one diode is turned on, the other diode is turned off.

The converting switch has the construction in which one of the two input terminals is connected to an output terminal. Therefore, when one input terminal is connected to the output terminal, the other input terminal is opened. Thus, a circuit connected to an upstream end of an open input terminal is opened, and signals of the circuit are prone to intrude into an output terminal, whereby isolation between the two input terminals deteriorates.

### SUMMARY OF THE INVENTION

It is an object of the invention to improve isolation between the two input terminals, and isolation between an input terminal that is not selected and an output terminal.

According to a first aspect of the invention, a switch circuit includes: a first input terminal; a second input terminal; an output terminal which is selectively connected to the first input terminal or the second input terminal; and terminators for terminating the first input terminal or the second input terminal. In this case, when the first input terminal is connected to the output terminal, the second input terminal is terminated by the terminator. Further, when the second input terminal is connected to the output terminal, the first input terminal is terminated by the terminator.

Preferably, each of the terminators is formed of a series circuit including a diode and a resistor, and the series circuits are connected between the first input terminal and a ground and between the second input terminal and a ground, respectively. Further, the diodes of the two series circuits are selectively turned on.

Preferably, the impedances of the series circuits when the diodes are turned on are set to the same as impedances of circuits that are connected to the first input terminal and the second input terminal, respectively.

Preferably, each of the terminators is composed of a trap circuit whose trap frequency is converted at a first frequency or a second frequency higher than the first frequency, and the trap circuits are connected between the first input terminal and a ground and between the second input terminal and a ground, respectively. When the trap circuit connects the first input terminal the output terminal, the first frequency is trapped by the trap circuit that is connected to the first input terminal, and the second frequency is trapped by the trap circuit that is connected to the second input terminal. Furthermore, when the trap circuit connects the second input terminal and the output terminal, the first frequency is trapped by the trap circuit that is connected to the second input terminal, and the second frequency is trapped by the trap circuit that is connected to the first input terminal.

Preferably, each of the trap circuits includes a diode, a resistor that is directly connected to the diode, a first capacitive element that is connected to the diode in parallel, and a series resonant circuit that is connected to the resistor in parallel. Further, the diodes of the two trap circuits are selectively turned on.

Preferably, the first frequency is set to be lower than the lowest frequency of the frequency band of signals that are input to the first input terminal and the second input terminal, and the second frequency is set to the vicinity of the highest frequency of the frequency band.

### BRIEF DESCRIPTION OF THE DRAWINGS

Fig. 1 is a circuit diagram illustrating a switch circuit according to a first embodiment of the invention;
Fig. 2 is a circuit diagram illustrating a switch circuit according to a second embodiment of the invention;
Fig. 3 is a graph illustrating the transmission characteristics of the switch circuit of the invention; and
Fig. 4 is a circuit diagram of a BS converter using a switch circuit according to the related art.

### DESCRIPTION OF THE PREFERRED EMBODIMENT

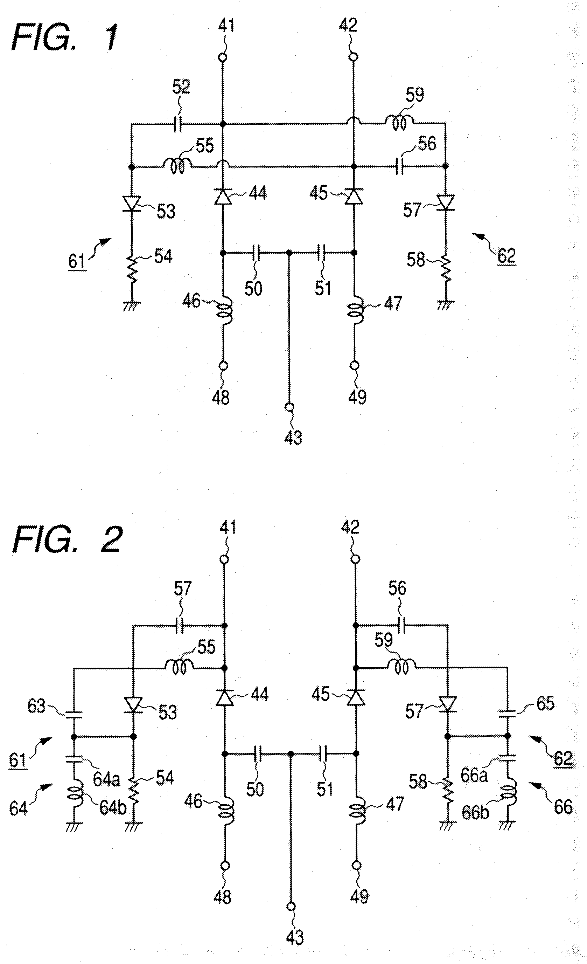

Hereinafter, a first embodiment of the invention will be described with reference to Fig. 1. A cathode of a first diode 44 is connected to a first input terminal 41. An anode of the first diode 44 is connected to a first control terminal 48 through a first choke inductor 46, and is connected to an output terminal 43 through a first DC cut capacitor 50. In addition, a cathode of a second diode 45 is connected to a second input terminal 42. An anode of the second diode 45 is connected to a second control terminal 49 through a second choke inductor 47, and is connected to the output terminal 43 through a second DC cut capacitor 51.

Further, the cathode of the first diode 44 is connected to an anode of a third diode 53 through a third DC cut capacitor 52, and is grounded through a first resistor 54. A first terminator 61 is composed of a series circuit including the third diode 53 and the first resistor 54. The anode of the third diode 53 is connected to the cathode of the second diode 45 through a third choke inductor 55. The cathode of the second diode 45 is connected to an anode of a fourth diode 57 through a fourth DC cut capacitor 56, and is grounded trough a second resistor 58. A second terminator 62 is composed of a series circuit including the fourth diode 57 and the second resistor 58. The anode of the fourth diode 57 is connected to the cathode of the first diode 44 through a fourth choke inductor 59.

Each of the first to fourth diodes 44, 45, 53, and 57 is composed of a pin diode, and each of the first to fourth DC cut capacitors 50, 51, 52, and 56 shows low impedance for a high frequency signal. Further, each of the resistance values of the first resistor 54 and the second resistor 58 is about 500.

Preceding ends of a first input terminal 41 and a second input terminal 42 are connected to, for example, mixers (not shown) for frequency conversion, respectively. Satellite broadcasting signals (intermediate frequency signals) in the range of 1 to 2.5 GHz, which are converted by the respective mixers so as to have intermediate frequencies, are input to the upstream ends. A right polarized intermediate frequency signal is input to the first input terminal 41, and a left polarized intermediate frequency signal is input to the second input terminal 42. An intermediate frequency amplifier (not shown) is connected to the output terminal 43. Further, any one of the right polarized intermediate frequency signal that is input to the first input terminal 41 and the left polarized intermediate frequency signal that is input to the second input terminal 42 is selected so as to be output to the output terminal 43.

When the intermediate frequency signal of the first input terminal 41 is output, a switching voltage is applied to the first control terminal 48 (not applied to the second control terminal 49) so as to turn on the first diode 44. At this time, since the fourth diode 57 is turned on, the second input terminal 42 is terminated by the series circuit including the fourth diode 57 and the second resistor 58. Therefore, the intermediate frequency signal input to the second input terminal 42 is not reflected, and thus a signal is prevented from intruding into the first input terminal 41 and the output terminal 43, whereby isolation is improved.

Similarly, when the intermediate frequency signal of the second input terminal 41 is output, a switching voltage is applied to the second control terminal 49 (not applied to the first control terminal 48) so as to turn on the second diode 45. At this time, since the third diode 53 is also turned on, the first input terminal 41 is terminated by the series circuit including the third diode 53 and the first resistor 54. Therefore, the intermediate frequency signal input to the first input terminal 41 is not reflected, and thus a signal is prevented from intruding into the second input terminal 42 and the output terminal 43, whereby isolation is improved.

Next, a second embodiment of the invention will be described with reference to Fig. 2. In Fig. 2, differences from the configuration of Fig. 1 are found in the first terminator 61 and the second terminator 62, and in that the third choke inductor 55 is connected between the anode of the third diode 53 and the cathode of the first diode 44, and the fourth choke inductor 59 is connected between the anode of the fourth diode 57 and the cathode of the second diode 45. The rest of the configuration is the same as that of Fig. 1.

In the first terminator 61, a first capacitive element 63 having low capacitance is connected to the third diode 53 in parallel, a first series resonant circuit 64 is connected to the first resistor 54 in parallel. The capacitance of the first capacitive element 63 is about 0.6 pF. The first series resonant circuit 64 includes a second capacitive element 64a and a first inductance element 64b, the capacitance of the second capacitive element 64a is about 8.0 pF, and the inductance of the first inductance element 64b is about 4.3 nH.

The second terminator 62 has the same configuration as the first terminator 61. That is, a third capacitive element 65 having low capacitance is connected to the fourth diode 57 in parallel, and a second series resonant circuit 66 is connected to the second resistor 58 in parallel. The capacitance of the third capacitive element 65 is about 0.6 pF. The series second resonance circuit 66 includes a fourth capacitive element 66a and a second inductance element 66b, the capacitance of the fourth capacitive element 66a is about 8.0 pF, and the inductance of the second inductance element 66b is about 4.3 nH.

Representative characteristics of the first terminator 61 will be described. When the third diode 53 is in the ON state, the first terminator 61 represents the resonance characteristics of the first series resonant circuit 64, and the resonance frequency thereof becomes about 860 MHz. In addition, when the third diode 53 is not in the ON state, the capacitance between the terminals of the third diode 53 is about 0.4 pF, and thus the resonance frequency becomes about 2570 MHz. Therefore, the first terminator 61 and the second terminator 62 function as trap circuits in which series resonance frequency is converted into 860 MHz or 2570 MHz.

When the first diode 44 is turned on, the third diode 53 is turned on as well, so that the first terminator 61 traps 860 MHz and the transmission characteristics between the first input terminal 41 and the output terminal 43 becomes like A shown in Fig. 3. However, the second diode 45 is not turned on, and the fourth diode 57 is not turned on as well, so that the second terminator 62 traps 2570 MHz and the transmission characteristics between the second input terminal 42 and the output terminal 43 becomes like B shown in Fig. 3. Here, if the second terminator 62 was not provided, the transmission characteristics between the second input terminal 42 and the output terminal 43 becomes like C shown in Fig. 3. In other words, the second terminator 62 is provided to improve isolation, even though transmission level increases and isolation deteriorates as the frequency increases.

When the second diode 45 is turned on and the first diode 44 is turned off, the relationship is reversed to the above-described relationship, whereby isolation can be improved as well.

According to the first aspect of the invention, a switch circuit includes a first input terminal; a second input terminal; an output terminal which is selectively connected to the first input terminal or the second input terminal; and terminators for terminating the first input terminal or the second input terminal. In this case, when the first input terminal is connected to the output terminal, the second input terminal is terminated by the terminator. Further, when the second input terminal is connected to the output terminal, the first input terminal is terminated by the terminator. Therefore, a signal input to the input terminal on the open side is not reflected, and thus a signal is prevented from intruding into the input terminal and the output terminal on the other side, whereby isolation is improved.

Preferably, each of the terminators is formed of a series circuit including a diode and a resistor, and the series circuits are connected between the first input terminal and a ground and between the second input terminal and a ground, respectively. Further, the diodes of the two series circuits are selectively turned on. Therefore, the input terminal on the open side can be terminated by a resistor.

Preferably, the impedances of the series circuits when the diodes are turned on are set to the same as impedances of circuits that are connected to the first input terminal and the second input terminal, respectively. Therefore, the input terminal on the open side can be terminated, in a state in which the impedances of upstream circuits connected to the input terminal on the open side are matched with each other.

Preferably, each of the terminators is composed of a trap circuit whose trap frequency is converted at a first frequency or a second frequency higher than the first frequency, and the trap circuits are connected between the first input terminal and a ground and between the second input terminal and a ground, respectively. When the trap circuit connects the first input terminal the output terminal, the first frequency is trapped by the trap circuit that is connected to the first input terminal, and the second frequency is trapped by the trap circuit that is connected to the second input terminal. Furthermore, when the trap circuit connects the second input terminal and the output terminal, the first frequency is trapped by the trap circuit that is connected to the second input terminal, and the second frequency is trapped by the trap circuit that is connected to the first input terminal. Therefore, a signal input to the input terminal on the open side can be attenuated, and signals are prevented from intruding into other input terminal and output terminal, whereby isolation is further improved. In particular, isolation at the high frequency band can be improved.

Preferably, each of the trap circuits includes a diode, a resistor that is directly connected to the diode, a first capacitive element that is connected to the diode in parallel, and a series resonant circuit that is connected to the resistor in parallel. Further, the diodes of the two trap circuits are selectively turned on. Therefore, the trap frequency can be converted between two of the frequencies.

Preferably, the first frequency is set to be lower than the lowest frequency of the frequency band of signals that are input to the first input terminal and the second input terminal, and the second frequency is set to the vicinity of the highest frequency of the frequency band. Therefore, it is possible to correct the frequency characteristics of input signals at the low frequency band, and high frequency band isolation at the terminal to which signals are not input.

## Claims

1. A switch circuit comprising:
a first input terminal (41);
a second input terminal (42);
an output terminal (43) which is selectively connected to the first input terminal (41) or the second input terminal (42); and
terminators (61, 62) for terminating the first input terminal (41) or the second input terminal (42),
wherein the first input terminal (41) is connected to the output terminal (43), the second input terminal (42) is terminated by the terminator (62), and
when the second input terminal (42) is connected to the output terminal (43), the first input terminal (41) is terminated by the terminator (61).

2. The switch circuit according to claim 1,
wherein each of the terminators (61, 62) is formed of a series circuit including a diode (53, 57) and a resistor (54, 58), and the series circuits are connected between the first input terminal (41) and a ground and between the second input terminal (42) and a ground, respectively, and
the diodes (53, 57) of the two series circuits are selectively turned on.

3. The switch circuit according to claim 2,
wherein the impedances of the series circuits when the diodes (53, 57) are turned on are set to the same as impedances of circuits that are connected to the first input terminal (41) and the second input terminal (42), respectively.

4. The switch circuit according to claim 1,
wherein each of the terminators (61, 62) is composed of a trap circuit whose trap frequency is converted at a first frequency or a second frequency higher than the first frequency, and the trap circuits are connected between the first input terminal (41) and a ground and between the second input terminal (42) and a ground, respectively,
when the trap circuit connects the first input terminal (41) and the output terminal (43), the first frequency is trapped by the trap circuit that is connected to the first input terminal (41), and the second frequency is trapped by the trap circuit that is connected to the second input terminal (42), and
when the trap circuit connects the second input terminal (42) and the output terminal (43), the first frequency is trapped by the trap circuit that is connected to the second input terminal (42), and the second frequency is trapped by the trap circuit that is connected to the first input terminal (41).

5. The switch circuit according to claim 4,
wherein each of the trap circuits includes a diode (53, 57), a resistor (54, 58) that is directly connected to the diode (53, 57), a first capacitive element (63) that is connected to the diode (53, 57) in parallel, and a series resonant circuit (64, 66) that is connected to the resistor (54, 58) in parallel, and
the diodes (53, 57) of the two trap circuits are selectively turned on.

6. The switch circuit according to claim 4 or 5,
wherein the first frequency is set to be lower than the lowest frequency at the frequency band of signals that are input to the first input terminal (41) and the second input terminal (42), and the second frequency is set to the vicinity of the highest frequency of the frequency band.
